(19) Europäisches Patentamt
European Patent Office
Office européen des brevets

(11) EP 4 691 762 A1

(12) **EUROPEAN PATENT APPLICATION**
published in accordance with Art. 153(4) EPC

(43) Date of publication:
**11.02.2026 Bulletin 2026/07**

(21) Application number: **24778377.2**

(22) Date of filing: **19.03.2024**

(51) International Patent Classification (IPC):
***B32B 15/088*** (2006.01) ***B32B 7/12*** (2006.01)
***C09J 7/28*** (2018.01) ***C09J 7/35*** (2018.01)
***C09J 179/08*** (2006.01) ***H05K 1/03*** (2006.01)

(52) Cooperative Patent Classification (CPC):
**B32B 7/12; B32B 15/088; C09J 7/28; C09J 7/35; C09J 179/08; H05K 1/03**

(86) International application number:
**PCT/IB2024/052629**

(87) International publication number:
**WO 2024/201211 (03.10.2024 Gazette 2024/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **29.03.2023 JP 2023053139**
**29.03.2023 JP 2023053140**
**07.03.2024 JP 2024034980**
**07.03.2024 JP 2024034981**

(71) Applicant: **ZACROS CORPORATION**
**Gangnam-gu, Seoul, 06160 (KR)**

(72) Inventors:
- **NOMURA, Tadahiro**
**Tokyo 112-0002 (JP)**
- **SAKURAGI, Takanori**
**Tokyo 112-0002 (JP)**
- **TAKEI, Kunihiro**
**Tokyo 112-0002 (JP)**

(74) Representative: **Godemeyer Blum Lenze Patentanwälte Partnerschaft mbB - werkpatent**
**An den Gärten 7**
**51491 Overath (DE)**

# (54) ADHESIVE-ATTACHED METAL SUBSTRATE, AND LAMINATE

(57) The present invention relates to an adhesive-attached metal substrate and a laminate, which are excellent in transmission characteristics and can sufficiently ensure adhesive strength between a resin substrate and a metal layer. More specifically, the present invention relates to an adhesive-attached metal substrate including a metal layer and an adhesive resin layer formed of an adhesive resin composition, in which the adhesive resin composition contains a polyimide resin (A), a maleimide compound (B), and a radical initiator, a mass ratio between the polyimide resin (A) and the maleimide compound (B) is 10:1 to 3:2, and the content of the radical initiator, with respect to 100 parts by mass of the maleimide compound (B), is equal to or more than 1 part by mass and less than 25 parts by mass, and a laminate including the adhesive-attached metal substrate.

Fig. 2

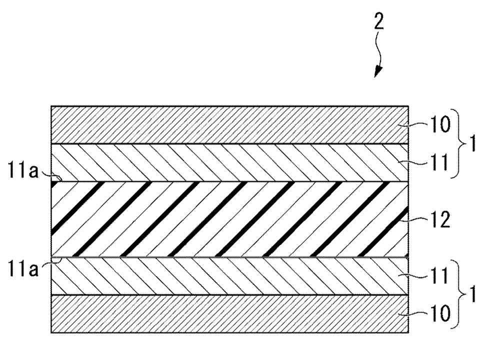


EP 4 691 762 A1

## Description

TECHNICAL FIELD

The present invention relates to an adhesive-attached metal substrate and a laminate.

BACKGROUND ART

A copper-clad laminate (hereinafter referred to as "CCL") used for transmission of a high-frequency signal is manufactured by laminating a copper foil and a resin layer.
In recent years, with an increase in speed of a transmission signal, CCL has been required to further improve transmission characteristics.
For example, Patent Literature 1 discloses a laminate in which a resin substrate and a metal substrate are laminated with an adhesive layer interposed therebetween. The adhesive layer included in the laminate disclosed in Patent Literature 1 has a relative permittivity of 3.0 or less and a dielectric loss tangent of 0.02 or less at a frequency of 1 MHz, which is in a low frequency band with respect to the frequency band of 5G.

CITATION LIST

Patent Literature

Patent Literature 1: Japanese Unexamined Patent Application, First Publication No. 2021-003886

SUMMARY OF INVENTION

TECHNICAL PROBLEM

In high frequency transmission, a current tends to flow only on the surface of metal wiring as the frequency band becomes higher. Therefore, if the shape of the surface is not smooth, a transmission loss increases. This is a known phenomenon called a "skin effect". In order to reduce the transmission loss caused by the skin effect, for example, a metal foil having a small surface roughness tends to be used for a metal substrate.
As the surface roughness of a metal foil decreases, an anchor effect is less likely to be obtained, and adhesion between a resin substrate and a metal foil decreases. In this case, the printed circuit board has a problem that circuit peeling easily occurs.
The present invention has been made in view of the above circumstances, and an objective of the present invention is to provide an adhesive-attached metal substrate and a laminate, which have excellent transmission characteristics and can sufficiently ensure adhesive strength between a resin substrate and a metal layer.

SOLUTION TO PROBLEM

That is, the present invention employs the following configuration.

[1] An adhesive-attached metal substrate including a metal layer and an adhesive resin layer formed of an adhesive resin composition, in which the metal layer has a surface roughness Rzjis of 1.5 μm or less, the adhesive resin composition contains a polyimide resin (A), a maleimide compound (B), and a radical initiator, a mass ratio between the polyimide resin (A) and the maleimide compound (B) is 10:1 to 3:2, and the content of the radical initiator, with respect to 100 parts by mass of the maleimide compound (B), is equal to or more than 1 part by mass and less than 25 parts by mass.
[2] The adhesive-attached metal substrate according to [1], in which the metal layer is a copper foil having a surface roughness Rzjis of less than 1.0 μm.
[3] A laminate including the adhesive-attached metal substrate according to [1] or [2] on both surfaces of a prepreg, in which the prepreg is laminated on a surface opposite a surface on which the adhesive resin layer included in the adhesive-attached metal substrate is in contact with the metal layer, and the prepreg is one or more selected from the group consisting of a modified polyimide resin prepreg, a polyester resin prepreg, a liquid crystal polymer prepreg, a cyclic olefin resin prepreg, a polyphenylene ether resin prepreg, a polyphenylene sulfide resin prepreg, a polyether ether ketone resin prepreg, a bismaleimide resin prepreg, a triazine resin prepreg, a bismaleimide-triazine resin prepreg, a benzocyclobutene resin prepreg, and a low dielectric epoxy resin prepreg.
[4] An adhesive-attached metal substrate including a metal layer and an adhesive resin layer formed of an adhesive

resin composition, in which the adhesive resin composition contains a polyimide resin (A), a maleimide compound (B), and a radical initiator, a mass ratio between the polyimide resin (A) and the maleimide compound (B) is 10:1 to 3:2, the content of the radical initiator, with respect to 100 parts by mass of the maleimide compound (B), is equal to or more than 1 part by mass and less than 25 parts by mass, and the adhesive resin layer has a thickness of 0.2 μm or more and 9 μm or less.

[5] The adhesive-attached metal substrate according to [4], in which the metal layer is a copper foil having a surface roughness Rzjis of 1.0 μm or less.

[6] The laminate including the adhesive-attached metal substrate according to [4] or [5] on both surfaces of a prepreg, in which the prepreg is laminated on a surface opposite a surface on which the adhesive resin layer included in the adhesive-attached metal substrate is in contact with the metal layer, and the prepreg is one or more selected from the group consisting of a modified polyimide resin prepreg, a polyester resin prepreg, a liquid crystal polymer prepreg, a cyclic olefin resin prepreg, a polyphenylene ether resin prepreg, a polyphenylene sulfide resin prepreg, a polyether ether ketone resin prepreg, a bismaleimide resin prepreg, a triazine resin prepreg, a bismaleimide-triazine resin prepreg, a benzocyclobutene resin prepreg, and a low dielectric epoxy resin prepreg.

[7] The laminate according to [6], in which the adhesive resin layer has a thickness of 0.2 μm or more and 9 μm or less, the prepreg has a thickness of 50 μm or more and 1000 μm or less, the metal layer has a thickness of 1 μm or more and 35 μm or less, and mathematical formula (1) below is satisfied:

$$0.05 \leqq (X/Y) \times 100 \leqq 7 \quad \cdots (1)$$

[in mathematical formula (1), X is the thickness (μm) of the adhesive resin layer, and Y is the thickness (μm) of the prepreg].

## ADVANTAGEOUS EFFECTS OF INVENTION

According to the present invention, there can be provided an adhesive-attached metal substrate and a laminate, which are excellent in transmission characteristics and can sufficiently ensure adhesive strength between a resin substrate and a metal layer.

## BRIEF DESCRIPTION OF DRAWINGS

Fig. 1 is a schematic cross-sectional view of an example of an adhesive-attached metal substrate according to the present embodiment.

Fig. 2 is a schematic cross-sectional view of an example of a laminate according to the present embodiment.

Fig. 3 is a graph of results of measuring transmission losses (dB/100 mm) of laminates of Example 21, Comparative Example 21, and Comparative Example 22.

## DESCRIPTION OF EMBODIMENTS

<Adhesive-attached metal substrate>

The adhesive-attached metal substrate of the present invention includes an adhesive-attached metal substrate X according to a first embodiment and an adhesive-attached metal substrate Y according to a second embodiment.

<<Adhesive-attached metal substrate X (first embodiment)>>

An adhesive-attached metal substrate X according to a first embodiment includes

a metal layer and an adhesive resin layer formed of an adhesive resin composition,
in which the metal layer has a surface roughness Rzjis of 1.5 μm or less,
the adhesive resin composition contains a polyimide resin (A), a maleimide compound (B), and a radical initiator,
a mass ratio between the polyimide resin (A) and the maleimide compound (B) is 10:1 to 3:2, and
the content of the radical initiator, with respect to 100 parts by mass of the maleimide compound (B), is equal to or more than 1 part by mass and less than 25 parts by mass.

Fig. 1 illustrates a cross-sectional schematic view of an adhesive-attached metal substrate 1 according to the

present embodiment. The adhesive-attached metal substrate 1 includes a metal layer 10 and an adhesive resin layer 11.

By combining and thermally laminating the adhesive-attached metal substrate 1 and an optional low dielectric substrate, a rigid substrate for high speed transmission can be produced.

For example, when a prepreg including a polyphenylene ether resin is used as a low dielectric substrate, a rigid substrate can be produced.

(Metal layer 10)

For the metal layer 10, any known conductive material usable for a circuit board can be used. Specifically, it is a metal material such as SUS, copper, aluminum, iron, steel, zinc, or nickel, or an alloy of the metal material.

The metal layer 10 is preferably a metal foil having a surface roughness of 1.5 μm or less, more preferably a metal foil having a surface roughness of 1.4 μm or less, further preferably a metal foil having a surface roughness of 1.3 μm or less, further more preferably a metal foil having a surface roughness of 1.0 μm or less, and particularly preferably a metal foil having a surface roughness of less than 1.0 μm.

The metal layer 10 is preferably a copper foil having a surface roughness of 1.5 μm or less, more preferably a copper foil having a surface roughness of 1.4 μm or less, further preferably a copper foil having a surface roughness of 1.3 μm or less, further more preferably a copper foil having a surface roughness of 1.0 μm or less, and particularly preferably a copper foil having a surface roughness of less than 1.0 μm.

The surface roughness in the present specification means ten-point average roughness (Rzjis).

The surface roughness of a metal foil such as a copper foil can be measured by, for example, a surface roughness measuring machine (model: SURFCOM 1900DX) manufactured by TOKYO SEIMITSU CO., LTD.

When the metal layer 10 is a copper foil, a rolled copper foil or an electrolytic copper foil as a copper foil can be used.

As a material of the copper foil, pure copper or a copper alloy in which a small amount of tin (Sn) or silver (Ag) is added to pure copper may be used.

The thickness of the metal layer 10 is preferably 5 μm or more, more preferably 10 μm or more, and further preferably 15 μm or more. The thickness of the metal layer 10 is preferably 50 μm or less, more preferably 45 μm or less, and further preferably 40 μm or less.

The upper limit value and the lower limit value of the thickness of the metal layer 10 can be optionally combined, and for example, the thickness of the metal layer 10 is 5 μm or more and 50 μm or less, 10 μm or more and 45 μm or less, or 15 μm or more and 40 μm or less.

(Adhesive resin layer 11)

The adhesive resin layer 11 is formed of an adhesive resin composition described later.

According to the adhesive-attached metal substrate 1, the metal layer 10 and an optional low dielectric substrate can be bonded via the adhesive resin layer 11.

The thickness of the adhesive resin layer 11 included in the adhesive-attached metal substrate 1 is preferably 0.2 μm or more, more preferably 0.5 μm or more, further preferably 0.6 μm or more, further more preferably 0.7 μm or more, particularly preferably 1.0 μm or more, and most preferably 1.2 μm or more. The thickness of the adhesive resin layer 11 is preferably 9 μm or less, more preferably 8 μm or less, further preferably 7 μm or less, further more preferably 5 μm or less, particularly preferably 4.8 μm or less, and most preferably 4.6 μm or less.

The upper limit value and the lower limit value of the thickness of the adhesive resin layer 11 can be optionally combined, and for example, the thickness of the adhesive resin layer 11 is 0.2 μm or more and 9 μm or less, 0.5 μm or more and 8 μm or less, or 0.7 μm or more and 7 μm or less.

When the thickness of the adhesive resin layer 11 is the above lower limit value or more, the metal layer 10 and a low dielectric substrate can be bonded to each other.

When the thickness of the adhesive resin layer 11 is equal to or less than the upper limit value, the adhesive resin layer 11 has a low residual solvent ratio, and delamination caused by a volatile gas hardly occurs in the heating step.

(Adhesive resin composition)

Hereinafter, an adhesive resin composition for forming the adhesive resin layer 11 will be described.

In the present embodiment, the adhesive resin layer 11 can be formed with a specific adhesive resin composition to provide, for example, an adhesive-attached metal substrate and a laminate, which can exhibit low dielectric characteristics in a high frequency region of 10 GHz which is a frequency band of 6 GHz or more when 5G is assumed.

It is considered that in a specific adhesive resin composition described later, the content of a maleimide compound which is one component of the precursor of the polyimide resin (A) satisfies a specific amount, so that the

resulting adhesive resin layer 11 exhibits low dielectric characteristics in a high frequency region. The maleimide group of the maleimide compound maintains a cyclic structure even after crosslinking, and has a symmetrical structure when the maleimide groups are crosslinked to each other. In this case, it is considered that molecular motion is easily suppressed, and the resulting adhesive resin layer 11 exhibits low dielectric characteristics in a high frequency region.

The adhesive resin composition contains a polyimide resin (A), a maleimide compound (B), and a radical initiator.

As the adhesive resin composition, the resin composition disclosed in International Publication WO 2022/004583 can be used.

This will be specifically described below.

[Polyimide resin (A)]

The polyimide resin (A) is an isocyanate-modified polyimide resin (A1) or a terminal-modified isocyanate-modified polyimide resin (A2). Hereinafter, the isocyanate-modified polyimide resin (A1) is referred to as a "polyimide resin (A1)", and the terminal-modified isocyanate-modified polyimide resin (A2) is referred to as a "polyimide resin (A2)".

- Polyimide resin (A1)

The polyimide resin (A1) is obtained by a reaction between a diisocyanate compound (a) and an intermediate polyimide resin. Hereinafter, the diisocyanate compound (a) is referred to as a "component (a)".

The intermediate polyimide resin is a reaction product of an aliphatic diamino compound (b) (hereinafter referred to as a "component (b)"), a tetrabasic acid dianhydride (c) (hereinafter referred to as a "component (c)"), and an aromatic diamino compound (d) (hereinafter referred to as a "component (d)").

The polyimide resin (A1) is a reaction product of either one or both of an amino group and an acid anhydride group at both terminals of the intermediate polyimide resin and an isocyanate group of the component (a).

The reaction between the intermediate polyimide resin and the component (a) is a copolymerization reaction between an amino group or an acid anhydride group at the terminals of the intermediate polyimide resin and an isocyanate group of the component (a). That is, it is a reaction in which a urea bond is formed by a reaction between an amino group and an isocyanate group and in which an imide bond is formed by a reaction between an acid anhydride and an isocyanate group.

As the amount of the component (a) used in the copolymerization reaction between the intermediate polyimide resin and the component (a), the isocyanate group of the component (a) is preferably less than 1 equivalent, more preferably 0.50 to 0.99 equivalent, and further preferably 0.67 to 0.98 equivalent, with respect to 1 equivalent of the terminal functional group of the intermediate polyimide resin.

By setting the use amount of the component (a) with respect to the intermediate polyimide resin within the above range, the polyimide resin (A1) has a sufficiently high molecular weight. Furthermore, the residual ratio of the unreacted raw material is reduced, and various properties such as heat resistance and flexibility after curing of the adhesive resin composition are improved.

Note that as described herein, the terminal functional group equivalent of the intermediate polyimide resin means a value calculated from the use amount of each material in synthesizing the intermediate polyimide resin.

The component (a) used in the synthesis of the polyimide resin (Al) is not particularly limited as long as it has two isocyanate groups in the molecule, and a plurality of diisocyanate compounds can be reacted at the same time.

The component (a) is preferably phenylene diisocyanate, tolylene diisocyanate, xylylene diisocyanate, tetramethylxylylene diisocyanate, diphenylmethane diisocyanate, naphthalene diisocyanate, tolidine diisocyanate, hexamethylene diisocyanate, dicyclohexylmethane diisocyanate, isophorone diisocyanate, arylene sulfone ether diisocyanate, allylcyan diisocyanate, N-acyl diisocyanate, trimethylhexamethylene diisocyanate, 1,3-bis(isocyanate methyl)cyclohexane, or norbornane-diisocyanate methyl. Among them, hexamethylene diisocyanate, trimethylhexamethylene diisocyanate, or isophorone diisocyanate, each being excellent in the balance among flexibility, adhesiveness, and the like, is more preferable.

The reaction between the intermediate polyimide resin and the component (a) may be performed by a known synthesis method.

Specifically, the polyimide resin (A1) can be obtained by adding the component (a) to an intermediate polyimide resin solution obtained by a later-described synthesis method, and heating and stirring the mixture at a temperature of 80°C or higher and 150°C or lower.

Note that the reaction time of the synthesis reaction of the intermediate polyimide resin or the reaction between the intermediate polyimide resin and the component (a) is greatly affected by the reaction temperature, but the reaction is preferably performed until the viscosity increase accompanying the progress of the reaction reaches equilibrium, and the maximum molecular weight is obtained. The reaction time is usually several tens of minutes to 10 hours.

In addition, the intermediate polyimide resin solution obtained as described above can be poured into a poor

solvent such as water, methanol, or hexane to separate the generated polymer and thereafter subjected to a reprecipitation method thereby to obtain the solid content of the polyimide resin (A1).

- Polyimide resin (A2)

The polyimide resin (A2) has either one or both of an amino group and an acid anhydride group at both terminals. Therefore, the terminal can be modified by reacting with a compound having one functional group capable of reacting with these functional groups to prepare a terminal-modified isocyanate-modified polyimide resin, i.e., the polyimide resin (A2).
Examples of the compound capable of reacting with either one or both of an amino group and an acid anhydride group include a compound having an acid anhydride group such as maleic anhydride, a compound having an alcoholic hydroxyl group such as hydroxyethyl acrylate, a compound having a phenolic hydroxyl group such as phenol, a compound having an isocyanate group such as 2-methacryloyloxyethyl isocyanate, and a compound having an epoxy group such as glycidyl methacrylate.
Since both terminals of the isocyanate compound of the present invention can be converted into functional groups other than an amino group and an acid anhydride group by modifying the terminals (for example, when terminal modification is performed with hydroxyethyl acrylate, the terminal of the isocyanate-modified polyimide resin can be converted into an acryloyl group), it is also possible to provide a composition combined with a compound that reacts with a functional group other than an amino group or an acid anhydride group.

-- Intermediate polyimide resin

The intermediate polyimide resin is a reaction product of the component (b), the component (c), and the component (d) described above.
The reaction of the component (b), the component (c), and the component (d) includes: a step of obtaining a polyamic acid by a copolymerization reaction between an amino group in the component (b) and the component (d) and an acid anhydride group in the component (c); and a step of obtaining an intermediate polyimide resin by a cyclodehydration reaction (imidization reaction) of the polyamic acid. These two steps may be performed separately, but it is efficient to perform them continuously and collectively.
When the number of moles of the component (b) used in the copolymerization reaction is MB, the number of moles of the component (c) is MC, and the number of moles of the component (d) is MD, both terminals of the obtained intermediate polyimide resin are amino groups in a case where the relationship of $MB + MD > MC$ is satisfied, and both terminals of the obtained intermediate polyimide resin are acid anhydride groups in a case where the relationship of $MB + MD < MC$ is satisfied.
Further, in a case where the relationship of $MB + MD = MC$ is satisfied, the molecular weight of the obtained intermediate polyimide resin theoretically reaches infinity, and one amino group and one acid anhydride group are included at both terminals.
An example of the amount of the component (b) used in the copolymerization reaction is preferably an amount in a range of 10 mass% or more and 50 mass% or less of a mass (this mass is substantially equal to the mass of the finally obtained isocyanate-modified polyimide resin) obtained by subtracting the mass of water generated in the cyclodehydration reaction step during synthesis of the intermediate polyimide resin from the sum of the mass of the component (b), the component (c), and the component (d) used in the synthesis step of the intermediate polyimide resin and the mass of the component (a) used in the above-described synthesis step of the polyimide resin (A1).
When the amount of the component (b) is less than the above range, the proportion of the aliphatic chain derived from the component (b) in the intermediate polyimide resin is too small, and the relative permittivity and the dielectric loss tangent become high. When the amount of the component (b) exceeds the above range, the proportion of the aliphatic chain derived from the component (b) in the intermediate polyimide resin is too large, and the heat resistance of the cured product is lowered.
The component (b) used for the synthesis of the intermediate polyimide resin is not particularly limited as long as it is an aliphatic compound having two amino groups in one molecule, but an aliphatic diamino compound having 6 to 36 carbon atoms is preferable.
Specific examples of the component (b) include hexamethylenediamine, 1,3-bis(aminomethyl)cyclohexane, a C14 branched diamine, a C18 branched diamine, a dimer diamine, and diaminopolysiloxane. These may be used individually or as a mixture of two or more thereof.
The dimer diamine described as a specific example of the component (b) is, as described herein, one in which two carboxy groups of a dimer acid as a dimer of an unsaturated fatty acid such as oleic acid are substituted with primary amino groups (for example, see Japanese Unexamined Patent Application, First Publication No. H9-012712).
Specific examples of commercially available products of the dimer diamine include PRIAMINE 1074 and PRIAMINE 1075 (manufactured by Croda Japan KK) and Versamine 551 (manufactured by Cognis Japan Co., Ltd.).

These may be used individually or as a mixture of two or more thereof.

The component (c) used for the synthesis of the intermediate polyimide resin is not particularly limited as long as it has two acid anhydride groups in one molecule.

Specific examples of the component (c) include pyromellitic anhydride, ethylene glycol-bis(anhydrotrimellitate), glycerin-bis(anhydrotrimellitate)monoacetate, 1,2,3,4-butanetetracarboxylic dianhydride, 3,3',4,4'-diphenylsulfonetetracarboxylic dianhydride, 3,3',4,4'-benzophenonetetracarboxylic dianhydride, 3,3',4,4'-biphenyltetracarboxylic dianhydride, 3,3',4,4'-diphenyl ether tetracarboxylic dianhydride, 5-(2,5-dioxotetrahydro-3-furanyl)-3-methylcyclohexene-1,2-dicarboxylic anhydride, 3a,4,5,9b-tetrahydro-5-(tetrahydro-2,5-dioxo-3-furanyl)-1,3-dione, 1,2,4,5-cyclohexanetetracarboxylic dianhydride, bicyclo(2,2,2)-oct-7-ene-2,3,5,6-tetracarboxylic dianhydride, bicyclo[2.2.2]octane-2,3,5,6-tetracarboxylic dianhydride, and 5,5'-((propane-2,2-diylbis(4,1-phenylene))bis(oxy))bis(isobenzofuran-1,3-dione).

Among them, 3,3',4,4'-diphenylsulfonetetracarboxylic dianhydride, 3,3',4,4'-benzophenonetetracarboxylic dianhydride, 3,3',4,4'-biphenyltetracarboxylic dianhydride, or 3,3',4,4'-diphenyl ether tetracarboxylic dianhydride is preferable from the viewpoint of solvent solubility, adhesion to a substrate, and photosensitivity. These may be used individually or as a mixture of two or more thereof.

The component (c) used for the synthesis of the intermediate polyimide resin preferably contains at least one compound selected from the group consisting of chemical formulas (1) to (4) below.

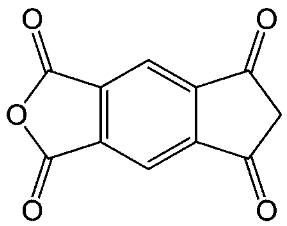

(1)

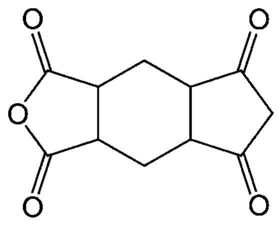

(2)

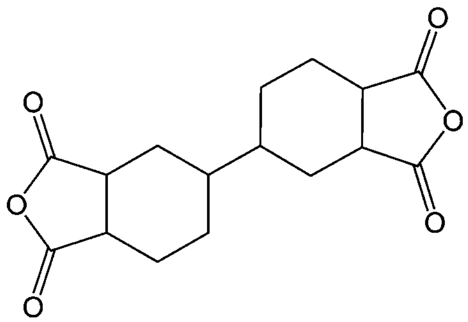

(3)

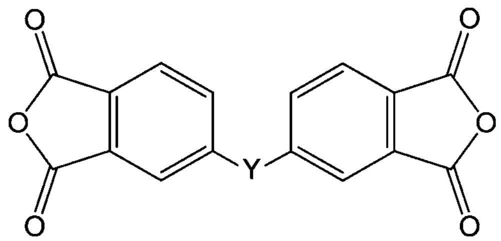

(4)

In chemical formula (4), Y represents $C(CF_3)_2$, $SO_2$, CO, O, a direct bond, or a divalent linking group represented by chemical formula (5) below. Note that the two linking moieties represented by chemical formula (5) are each a moiety that binds to a phthalic anhydride.

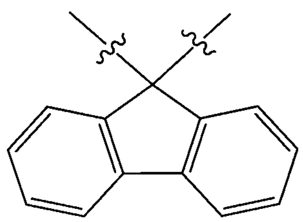

(5)

The component (d) used for the synthesis of the intermediate polyimide resin is not particularly limited as long as it is an aromatic compound having two amino groups in one molecule.

Specific examples of the component (d) include m-phenylenediamine, p-phenylenediamine, m-tolylenediamine, 4,4'-diaminodiphenyl ether, 3,3'-dimethyl-4,4'-diaminodiphenyl ether, 3,4'-diaminodiphenyl ether, 4,4'-diaminodiphenyl thioether, 3,3'-dimethyl-4,4'-diaminodiphenyl thioether, 3,3'-diethoxy-4,4'-diaminodiphenyl thioether, 3,3'-diaminodiphenyl thioether, 4,4'-diaminobenzophenone, 3,3'-dimethyl-4,4'-diaminobenzophenone, 3,3'-diaminodiphenylmethane, 4,4'-diaminodiphenylmethane, 3,4'-diaminodiphenylmethane, 3,3'-dimethoxy-4,4'-diaminodiphenylthioether, 2,2'-bis(3-aminophenyl)propane, 2,2'-bis(4-aminophenyl)propane, 4,4'-diaminodiphenyl sulfoxide, 3,3'-diaminodiphenyl sulfone, 4,4'-diaminodiphenyl sulfone, benzidine, 3,3'-dimethylbenzidine, 3,3'-dimethoxybenzidine, 3,3'-diaminobiphenyl, p-xylylenediamine, m-xylylenediamine, o-xylylenediamine, 2,2'-bis(3-aminophenoxyphenyl)propane, 2,2'-bis(4-aminophenoxyphenyl)propane, 1,3-bis(4-aminophenoxyphenyl)benzene, 1,3'-bis(3-aminophenoxyphenyl)propane, bis(4-amino-3-methylphenyl)methane, bis(4-amino-3,5-dimethylphenyl)methane, bis(4-amino-3-ethylphenyl)methane, bis(4-amino-3,5-diethylphenyl)methane, bis(4-amino-3-propylphenyl)methane, and bis(4-amino-3,5-dipropylphenyl) methane. These may be used individually or as a mixture of two or more thereof.

The component (d) used for the synthesis of the intermediate polyimide resin preferably contains at least one compound selected from the group consisting of chemical formulas (6) and (8) below.

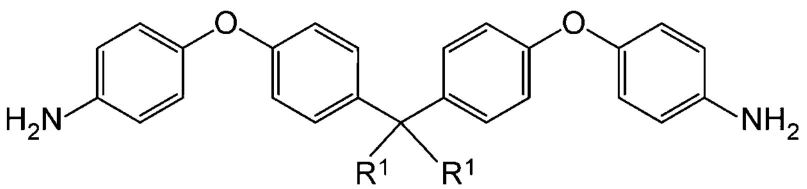

(6)

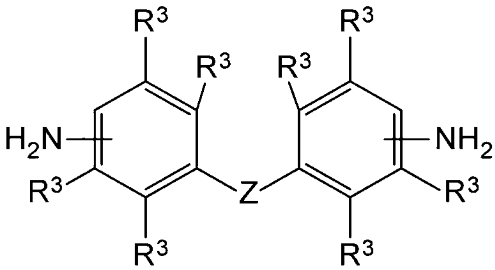

(8)

In chemical formula (6), $R^1$ represents a methyl group or a trifluoromethyl group. In chemical formula (8), Z represents $CH(CH_3)$, $SO_2$, $CH_2$, $O-C_6H_4-O$, O, a direct bond, or a divalent linking group represented by chemical formula (5) above, and $R^3$ represents a hydrogen atom, a methyl group, an ethyl group, or a trifluoromethyl group. Note that the two linking moieties represented by chemical formula (5) are each a moiety that binds to a phthalic anhydride.

The intermediate polyimide resin can be synthesized by a known method.

For example, a solvent, a dehydrating agent, and a catalyst are added to a mixture of the components (b) to (d) used for synthesis, and the mixture is heated and stirred at 100 to 300°C under an inert gas atmosphere such as nitrogen, so that an imidization reaction (ring-closing reaction accompanied by dehydration) occurs through a polyamic acid, and an intermediate polyimide resin solution is obtained. At this time, water generated in association with imidization is distilled off to the outside of the system, and the dehydrating agent and the catalyst are also distilled off to the outside of the system after the completion of the reaction, so that an intermediate polyimide resin having high purity can be obtained without requiring washing. Examples of the dehydrating agent include toluene and xylene, and examples of the catalyst include pyridine and triethylamine.

Examples of the solvent usable in the synthesis of the intermediate polyimide resin include, but are not limited to, methyl ethyl ketone, methyl propyl ketone, methyl isopropyl ketone, methyl butyl ketone, methyl isobutyl ketone, methyl n-hexyl ketone, diethyl ketone, diisopropyl ketone, diisobutyl ketone, cyclopentanone, cyclohexanone, methyl cyclohexanone, acetylacetone, γ-butyrolactone, diacetone alcohol, cyclohexen-1-one, dipropyl ether, diisopropyl ether, dibutyl ether, tetrahydrofuran, tetrahydropyran, ethyl isoamyl ether, ethyl-t-butyl ether, ethyl benzyl ether, cresyl methyl ether, anisole, phenetol, methyl acetate, ethyl acetate, propyl acetate, isopropyl acetate, butyl acetate, isobutyl acetate, amyl acetate, isoamyl acetate, 2-ethylhexyl acetate, cyclohexyl acetate, methyl cyclohexyl acetate, benzyl acetate, methyl acetoacetate, ethyl acetoacetate, methyl propionate, ethyl propionate, butyl propionate, benzyl propionate, methyl butyrate, ethyl butyrate, isopropyl butyrate, butyl butyrate, isoamyl butyrate, methyl lactate, ethyl lactate, butyl lactate, ethyl isovalerate, isoamyl isovalerate, diethyl oxalate, dibutyl oxalate, methyl benzoate, ethyl benzoate, propyl benzoate, methyl salicylate, N-methylpyrrolidone, N,N-dimethylformamide, N,N-dimethylacetamide, and dimethyl sulfoxide. These may be used individually or as a mixture of two or more thereof.

[Maleimide compound (B)]

The maleimide compound (B) is not particularly limited as long as it is a compound having one or more maleimide groups in one molecule, but a compound having two or more maleimide groups in one molecule is preferable. Examples thereof include a polyfunctional maleimide compound obtained by a reaction of 3,4,4'-triaminodiphenylmethane, triaminophenol, or the like with maleic anhydride, a maleimide compound obtained by a reaction of tris(4-aminophenyl) phosphate, tris(4-aminophenyl)phosphate, or tris(4-aminophenyl)thiophosphate with maleic anhydride, a trismaleimide compound such as tris(4-maleimidephenyl)methane, a tetramaleimide compound such as a maleimide obtained by a reaction of bis(3,4-dimaleimidephenyl)methane, tetramaleimidebenzophenone, tetramaleimidenaphthalene, or triethylenetetramine with maleic anhydride, a phenol novolac-type maleimide resin, an isopropylidenebis(phenoxyphenylmaleimide)phenylmaleimidearalkyl resin, and a biphenylene-type phenylmaleimidearalkyl resin. Examples of the commercially available product include MIR-3000 and MIR-5000 (manufactured by Nippon Kayaku Co., Ltd.), BMI-70 and BMI-80 (manufactured by K.I Chemical Industry Co., Ltd.), and BMI-1000, BMI-2000, and BMI-3000 (manufactured by Daiwa Kasei Industrial Co., Ltd.).

Since maleimide groups in a maleimide compound are self-crosslinked by the action of a radical initiator, a resin composition using an isocyanate-modified polyimide resin having an amino group at the terminal, a maleimide compound, and a radical initiator becomes a cured product in which maleimide groups are self-crosslinked by heating and in which a polyimide resin and a maleimide resin are copolymerized.

[Radical initiator]

Examples of the radical initiator usable for the self-crosslinking between maleimide groups include peroxides such as dicumyl peroxide and dibutyl peroxide and azo compounds such as 2,2'-azobis(isobutyronitrile) and 2,2'-azobis(2,4-dimethylvaleronitrile).

The mass ratio between the polyimide resin (A) and the maleimide compound (B) in the adhesive resin composition used in the present embodiment is 10:1 to 3:2, and preferably 7:1 to 5:2.

When the mass ratio between the polyimide resin (A) and the maleimide compound (B) is in the above range, an adhesive-attached metal substrate and a laminate, which have low dielectric characteristics in a high frequency region, are obtained. In addition, even a metal foil having a low surface roughness of 1.5 μm or less is likely to adhere and exert high adhesive strength.

The content of the radical initiator in the adhesive resin composition used in the present embodiment, with respect to 100 parts by mass of the maleimide compound (B), is equal to or more than 1 part by mass and less than 25 parts by mass, and preferably 5 parts by mass or more and 20 parts by mass or less.

When the content of the radical initiator satisfies the above range, an adhesive-attached metal substrate and a laminate, which can sufficiently ensure adhesive strength between a resin film and a metal layer, are obtained. In particular, even a metal foil having a low surface roughness of 1.5 μm or less is likely to adhere and exhibit high adhesive strength.

The adhesive resin composition used in the present embodiment may contain an organic solvent.

Specific examples of the organic solvent include γ-butyrolactones; amide-based solvents such as N-methylpyrrolidone, N,N-dimethylformamide, N,N-dimethylacetamide, and N,N-dimethylimidazolidinone; sulfones such as tetramethylene sulfone; ether-based solvents such as diethylene glycol dimethyl ether, diethylene glycol diethyl ether, propylene glycol, propylene glycol monomethyl ether, propylene glycol monomethyl ether monoacetate, and propylene glycol monobutyl ether; ketone-based solvents such as methyl ethyl ketone, methyl isobutyl ketone, cyclopentanone, and cyclohexanone; and aromatic solvents such as toluene and xylene.

The organic solvent is preferably used in such a ratio that the solid content concentration in the adhesive resin composition excluding the organic solvent is usually 5 mass% or more and 80 mass% or less, and preferably 10 mass% or more and 70 mass% or less.

The adhesive resin composition can be produced by adding a main agent containing the polyimide resin (A) and the maleimide compound (B) to an organic solvent, and further adding the radical initiator.

<Laminate>

The laminate of the present embodiment includes the adhesive-attached metal substrate of the present embodiment on both surfaces of a prepreg.

Fig. 2 is a cross-sectional schematic view of a laminate 2 of the present embodiment. The laminate 2 includes the adhesive-attached metal substrate 1 on both surfaces of a prepreg 12.

The prepreg 12 is laminated on a surface 11a opposite a surface on which the adhesive resin layer 11 of the adhesive-attached metal substrate 1 is in contact with the metal layer 10.

That is, the laminate 2 includes the metal layer 10, the adhesive resin layer 11, the prepreg 12, the adhesive resin layer 11, and the metal layer 10 laminated in this order.

(Prepreg)

The prepreg 12 is preferably one or more selected from the group consisting of a modified polyimide resin

prepreg, a polyester resin prepreg, a liquid crystal polymer prepreg, a cyclic olefin resin prepreg, a polyphenylene ether resin prepreg, a polyphenylene sulfide resin prepreg, a polyether ether ketone resin prepreg, a bismaleimide resin prepreg, a triazine resin prepreg, a bismaleimide-triazine resin prepreg, a benzocyclobutene resin prepreg, and a low dielectric epoxy resin prepreg.

In the laminate 2 including an adhesive-attached metal substrate X according to the first embodiment, the thickness of the adhesive resin layer 11 is preferably 0.2 μm or more and 9 μm or less, and the thickness of the metal layer 10 is preferably 5 μm or more and 50 μm or less.

An example of the laminate 2 is a copper-clad laminate.

<<Adhesive-attached metal substrate Y (second embodiment)>>

In the adhesive-attached metal substrate X according to the first embodiment described above, the surface roughness Rzjis of the metal layer provided in the adhesive-attached metal substrate is 1.5 μm or less, but in an adhesive-attached metal substrate Y according to a second embodiment, the thickness of the adhesive resin layer provided in the adhesive-attached metal substrate is 0.2 μm or more and 9 μm or less.

Specifically, the adhesive-attached metal substrate Y according to the second embodiment includes

a metal layer and an adhesive resin layer formed of an adhesive resin composition,
in which the adhesive resin composition contains a polyimide resin (A), a maleimide compound (B), and a radical initiator,
a mass ratio between the polyimide resin (A) and the maleimide compound (B) is 10:1 to 3:2,
the content of the radical initiator, with respect to 100 parts by mass of the maleimide compound (B), is equal to or more than 1 part by mass and less than 25 parts by mass, and
a thickness of the adhesive resin layer is 0.2 μm or more and 9 μm or less.

As described above, the adhesive-attached metal substrate Y according to the second embodiment is the same as the adhesive-attached metal substrate X according to the first embodiment except that the thickness of the adhesive resin layer falls within a specific range, and the detailed description thereof will be omitted. However, in the laminate 2 including the adhesive-attached metal substrate Y according to the second embodiment, it is preferable that the thickness of the adhesive resin layer 11 is 0.2 μm or more and 9 μm or less, the thickness of the metal layer 10 is 1 μm or more and 35 μm or less, and the thickness of the prepreg is 50 μm or more and 1000 μm or less.

In addition, it is preferable that the laminate 2 including the adhesive-attached metal substrate Y according to the second embodiment satisfies mathematical formula (1).

$$0.01 \leqq (X/Y) \times 100 \leqq 7 \quad \cdots (1)$$

[In mathematical formula (1), X is the thickness (μm) of the adhesive resin layer, and Y is the thickness (μm) of the prepreg.]

The above mathematical formula (1) is preferably one of the following formulas (1)-1 to (1)-3.

$$0.05 \leqq (X/Y) \times 100 \leqq 7 \quad \cdots (1)\text{-}1$$

$$0.2 \leqq (X/Y) \times 100 \leqq 6.5 \quad \cdots (1)\text{-}2$$

$$0.4 \leqq (X/Y) \times 100 \leqq 6 \quad \cdots (1)\text{-}3$$

EXAMPLES

Hereinafter, the present invention will be described more specifically as examples, but the present invention is not limited to these examples.

<<Adhesive-attached metal substrate X and laminate thereof>>

<Preparation of adhesive resin composition>

The polyimide resin (A) and the maleimide compound (B) were mixed at a mass ratio of 4:1 to form a main agent, and the main agent was dissolved in anisole. Subsequently, 17 parts by mass of dicumyl peroxide (manufactured by

Sigma-Aldrich Co. LLC.) was added to 100 parts by mass of the maleimide compound (B) and diluted with an organic solvent (anisole:toluene =9:1) to prepare an adhesive resin composition 1 having a solid content concentration of 11 mass%.

<Production of adhesive-attached metal substrate X>

(Example 1)

The obtained adhesive resin composition 1 was applied on an electrolytic copper foil (CF-T9DA-SV manufactured by Fukuda Metal Foil & Powder Co., Ltd.) having a surface roughness Rzjis of 0.85 μm and a thickness of 18 μm as a metal layer using a bar coater such that the adhesive resin layer had a thickness of 6 μm after drying, and the coat was thereafter dried at 140°C for 1 minute until the residual solvent ratio became 1%, thereby to produce an adhesive-attached metal substrate of Example 1.

(Comparative Example 1)

An adhesive-attached metal substrate of Comparative Example 1 was produced by the same method as in Example 1 except that as the metal layer, an electrolytic copper foil (CF-T4X-SV-9 manufactured by Fukuda Metal Foil & Powder Co., Ltd.) having a surface roughness Rzjis of 1.6 μm and a thickness of 9 μm was used.

(Reference Example 1)

An electrolytic copper foil (CF-T4X-SV-18 manufactured by Fukuda Metal Foil & Powder Co., Ltd.) having a surface roughness Rzjis of 1.0 μm and a thickness of 18 μm was used as Reference Example 1.

(Reference Example 2)

An electrolytic copper foil (CF-T9DA-SV manufactured by Fukuda Metal Foil & Powder Co., Ltd.) having a surface roughness Rzjis of 0.85 μm and a thickness of 18 μm was used as Reference Example 2.

(Reference Example 3)

An electrolytic copper foil (HS1-VSP manufactured by Mitsui Mining & Smelting Co., Ltd.) having a surface roughness Rzjis of 1.5 μm and a thickness of 18 μm was used as Reference Example 3.

<Production of laminate>

(Type of prepreg)

As prepregs, five types of polyphenylene ether resin prepregs and two types of bismaleimide-triazine resin prepregs were used. Hereinafter, the polyphenylene ether resin prepreg is referred to as a "PPE-based prepreg", and the bismaleimide-triazine resin prepreg is referred to as a "BT-based prepreg".

(PPE-based prepreg)

- PPE-based prepreg 1 (PPE1): Meteorwave (registered trademark) 4000 manufactured by AGC Inc., thickness: 110.3 μm
- PPE-based prepreg 2 (PPE2): MEGTRON (registered trademark) 4 manufactured by Panasonic Industry Co., Ltd., thickness: 100.5 μm
- PPE-based prepreg 3 (PPE3): MEGTRON (registered trademark) 6 manufactured by Panasonic Industry Co., Ltd., thickness: 130.3 μm
- PPE-based prepreg 4 (PPE4): MEGTRON (registered trademark) 7 manufactured by Panasonic Industry Co., Ltd., thickness: 140.5 μm
- PPE-based prepreg 5 (PPE5): commercially available prepreg having a relative permittivity of 3.6 and a dielectric loss tangent of 0.0041 at 10 GHz, thickness: 100 μm

(BT-based prepreg)

- BT-based prepreg 1 (BT1): N5000 manufactured by AGC Inc., thickness: 30 μm
- BT-based prepreg 2 (BT2): GHPL-970LF manufactured by MITSUBISHI GAS CHEMICAL COMPANY, INC., thickness: 45 μm

The adhesive-attached metal substrates of Example 1 and Comparative Example 1 were each laminated on both surfaces of a prepreg in the order of copper foil (metal layer)/adhesive resin layer/prepreg/adhesive resin layer/copper foil (metal layer).

When the metal substrates of Reference Examples 1 and 2 were used, each was laminated in the order of copper foil (metal layer)/prepreg/copper foil (metal layer).

The lamination conditions vary depending on the type of prepreg, and lamination was performed under the conditions described in Table 1 below.

[Table 1]

| | Lamination conditions | |
|---|---|---|
| PPE-based prepreg 1 | 210°C, 60 min | 2.7 MPa |
| PPE-based prepreg 2 | 200°C, 80 min | 2 to 3 MPa |
| PPE-based prepreg 3 | 185°C, 75 min | 2.9 to 3.9 MPa |
| PPE-based prepreg 4 | 195°C, 75 min | 3 to 4 MPa |
| PPE-based prepreg 5 | 220°C, 60 min | 2 MPa |
| BT-based prepreg 1 | 190°C, 90 min | 1.4 to 2.4 MPa |
| BT-based prepreg 2 | 200°C, 60 min | 3 MPa |

Thus, laminates 1A to 1D, 2A to 2D, 3A to 3D, 4A to 4D, 5A, 5D, 6A to 6D, and 7A to 7D were produced.

<Measurement of adhesive strength>

For the obtained laminate, the adhesive strength between the copper foil (metal layer) and the prepreg was measured. The obtained laminate was cut into a width of 10 mm to prepare a test piece, the prepreg side was pasted on a ring core having a diameter of 11 cm, and the copper foil (metal layer) portion was pulled at a speed of 50 mm/min to perform a 90° peel test.

In this measurement, a case where the adhesive strength was 0.60 N/mm or more (3.4 lbs/inch or more) was evaluated as "adhesive strength can be sufficiently ensured". The adhesive strength of the produced laminate is described in Table 2.

Note that the adhesive strength is required to be 0.60 N/mm or more (3.4 lbs/inch or more) as an index of the adhesive strength between the prepreg and the metal layer, from the viewpoint of preventing peeling of the metal layer in the production process. Therefore, 0.60 N/mm or more (3.4 lbs/inch or more) was defined as an acceptable value.

<Solder heat resistance>

The produced laminate was left to stand in a thermostatic chamber at a temperature of 23°C and a humidity of 50% for 24 hours, and then floated in a solder bath at 288°C. The time until deformation or foaming occurred was measured to evaluate heat resistance. The results are shown in Table 2. A case where deformation or foaming did not occur for 300 seconds was evaluated as acceptable.

<Measurement of dielectric characteristics>

For the obtained laminate, the copper foil (metal layer) was removed by etching to prepare a test piece (50 mm in width and 100 mm in length) in which the adhesive resin layer, the prepreg, and the adhesive resin layer were laminated in this order, the test piece dried at 135°C for 1 hour was defined as a test piece "after drying", and the test piece dried and thereafter further allowed to stand for 24 hours under the conditions of 23°C and a humidity of 50% was defined as a test

piece "after humidity control". Dielectric characteristics were measured for each of the test pieces.

For dielectric characteristics, the relative permittivity and the dielectric loss tangent were measured at a frequency of 10 GHz by a split-post dielectric resonator method using a resonator manufactured by QWED Company.

For the laminates 1A to 1D, 2A to 2D, 3A to 3D, 4A to 4D, 5A to 5D, 6A to 6D, and 7A to 7D, the type of adhesive-attached metal substrate, the type of prepreg, the adhesive strength, the solder heat resistance, and the dielectric characteristics are shown in Table 2.

[Table 2]

| | Adhesive attached metal substrate | Prepreg | Adhesive strength measurement | | | Solder heat resistance | | Transmission characteristics | |
|---|---|---|---|---|---|---|---|---|---|
| | | | [N/mm] | [lbs/inch] | Determination | [sec] | Determination | Relative permittivity (Dk) | Dielectric loss tangent (Df) |
| Laminate 1A | Example 1 | PPE1 | 0.87 | 4.97 | OK | > 600 | OK | 3.61 | 0.0026 |
| Laminate 1B | Comparative Example 1 | | 0.94 | 5.37 | OK | > 600 | OK | 3.61 | 0.0026 |
| Laminate 1C | Reference Example 1 | | 0.35 | 2.00 | NG | > 600 | OK | 3.66 | 0.0026 |
| Laminate 1D | Reference Example 2 | | 0.07 | 0.40 | NG | > 600 | OK | 3.66 | 0.0026 |
| Laminate 2A | Example 1 | PPE2 | 0.90 | 5.14 | OK | > 600 | OK | 4.10 | 0.0080 |
| Laminate 2B | Comparative Example 1 | | 1.09 | 6.22 | OK | > 600 | OK | 4.10 | 0.0080 |
| Laminate 2C | Reference Example 1 | | 0.50 | 2.86 | NG | > 600 | OK | 4.14 | 0.0081 |
| Laminate 2D | **Reference** Example 2 | | 0.37 | 2.11 | NG | > 600 | OK | 4.14 | 0.0081 |
| Laminate 3A | Example 1 | PPE3 | 0.81 | 4.63 | OK | > 600 | OK | 3.83 | 0.0053 |
| Laminate 3B | Comparative Example 1 | | 0.93 | 5.31 | OK | > 600 | OK | 3.83 | 0.0053 |
| Laminate 3C | Reference Example 1 | | 0.36 | 2.06 | NG | > 600 | OK | 4.00 | 0.0053 |
| Laminate 3D | Reference Example 2 | | 0.36 | 2.06 | NG | > 600 | OK | 4.00 | 0.0053 |
| Laminate 4A | Example 1 | PPE4 | 0.84 | 4.80 | OK | > 600 | OK | 3.32 | 0.0023 |
| Laminate 4B | Comparative Example 1 | | 1.11 | 6.34 | OK | > 600 | OK | 3.32 | 0.0023 |
| Laminate 4C | Reference Example 1 | | 0.63 | 3.60 | OK | > 600 | OK | 3.27 | 0.0022 |
| Laminate 4D | Reference Example 2 | | 0.56 | 3.20 | NG | > 600 | OK | 3.27 | 0.0022 |
| Laminate 5A | Example 1 | PPE5 | 0.84 | 4.80 | OK | > 300 | OK | 3.73 | 0.0043 |
| Laminate 5D | Reference Example 2 | | 0.44 | 2.50 | NG | > 300 | OK | 3.77 | 0.0045 |
| Laminate 6A | Example 1 | BT1 | 0.95 | 5.42 | OK | 360 | OK | 3.86 | 0.0110 |
| Laminate 6B | Comparative Example 1 | | 1.10 | 6.28 | OK | 470 | OK | 3.86 | 0.0110 |
| Laminate 6C | Reference Example 1 | | 0.59 | 3.37 | NG | > 600 | OK | 3.86 | 0.0114 |
| Laminate 6D | Reference Example 2 | | 0.41 | 2.34 | NG | 125 | NG | 3.86 | 0.0114 |

(continued)

| | Adhesive attached metal substrate | Prepreg | Adhesive strength measurement | | | Solder heat resistance | | Transmission characteristics | |
|---|---|---|---|---|---|---|---|---|---|
| | | | [N/mm] | [lbs/inch] | Determination | [sec] | Determination | Relative permittivity (Dk) | Dielectric loss tangent (Df) |
| Laminate 7A | Example 1 | BT2 | 0.96 | 5.48 | OK | > 600 | OK | 3.48 | 0.0043 |
| Laminate 7B | Comparative Example 1 | | 1.09 | 6.22 | OK | > 600 | OK | 3.48 | 0.0043 |
| Laminate 7C | Reference Example 1 | | 0.53 | 3.03 | OK | > 600 | OK | 3.59 | 0.0045 |
| Laminate 7D | Reference Example 2 | | 0.48 | 2.74 | NG | > 600 | OK | 3.59 | 0.0045 |

As shown in Table 2, a comparison between the laminates of Reference Examples 1 and 2 with the laminate of Example 1 demonstrated that Example 1 had higher adhesive strength than Reference Examples 1 and 2.

Further, a comparison between the laminates of Example 1 and Comparative Example 1 demonstrated that Example 1 had better adhesive strength and transmission characteristics than Comparative Example 1.

<<Adhesive-attached metal substrate Y and laminate thereof>>

<Preparation of adhesive resin composition>

The polyimide resin (A) and the maleimide compound (B) were mixed at a mass ratio of 4:1 to form a main agent, and the main agent was dissolved in anisole. Subsequently, 17 parts by mass of dicumyl peroxide (manufactured by Sigma-Aldrich Co. LLC.) was added to 100 parts by mass of the maleimide compound (B) and diluted with an organic solvent (anisole:toluene =9:1) to prepare an adhesive resin composition 2 having an adjusted solid content concentration.

The solid content concentration was adjusted to the following concentration depending on the thickness of the adhesive resin layer.

- The thickness of the adhesive resin layer is 1 to 6 μm: the solid content concentration was adjusted to 11 mass% and applied using a bar coater.
- The thickness of the adhesive resin layer exceeds 10 μm: the solid content concentration was adjusted to 11 mass% and applied using an applicator.
- The thickness of the adhesive resin layer is less than 0.1 μm: the solid content concentration was adjusted to 1 mass% and applied using a bar coater.

<Production of adhesive-attached metal substrate Y>

(Example 11)

The obtained adhesive resin composition 2 was applied on an electrolytic copper foil (CF-T9DA-SV manufactured by Fukuda Metal Foil & Powder Co., Ltd.) having a surface roughness Rzjis of 0.85 μm and a thickness of 18 μm as a metal layer using an applicator or a bar coater such that the adhesive resin layer had a thickness of 6 μm after drying, and the coat was thereafter dried at 140°C for 1 minute until the residual solvent ratio became 1%, thereby to produce an adhesive-attached metal substrate of Example 11.

(Examples 12 to 16 and Comparative Examples 11 and 12)

Adhesive-attached metal substrates of Examples 12 to 16 and Comparative Examples 11 and 12 were each produced by the same method as in Example 11 except that the thickness of the adhesive resin layer was changed to the thickness shown in the following Table 3.

[Table 3]

| | Thickness (μm) of adhesive resin layer | Residual solvent ratio (%) |
|---|---|---|
| Example 11 | 6.0 | 0.65 |
| Example 12 | 5.\0 | |
| Example 13 | 3.0 | 0.55 |
| Example 14 | 2.0 | |
| Example 15 | 1.0 | |
| Example 16 | 0.5 | |
| Comparative Example 11 | 10.0 | 0.85 |
| Comparative Example 12 | 0.1 | |

<Processability evaluation>

As the processability evaluation, the residual solvent ratio and the processing speed were evaluated.

(Residual solvent ratio)

Adhesive resin layers having the same thicknesses as in Examples 11 and 13 and Comparative Example 11 respectively were each formed on a polyimide sheet, and dried at 120°C for 10 minutes. Then, the residual ratio of the organic solvent was measured. TG/DTA was used for the measurement.

The results are shown in Table 3. As described in Table 3, Comparative Example 11 in which the adhesive resin layer had a thickness of 10.0 μm had a high residual solvent ratio of 0.85%. When the residual solvent ratio is high, gas volatilizes from the adhesive resin layer in the heating step, which causes delamination.

On the other hand, in Examples 11 and 13 in which the thickness of the adhesive resin layer was 6.0 μm or 3.0 μm, it was found that the residual solvent ratio was low, and the possibility of delamination due to gas generation was low.

(Processing speed)

A coater test was performed assuming an adhesive coating step in which the copper foil was in a roll state, and the processing speed was measured when the equivalent residual solvent ratio (0.7% or less) was obtained under the same drying conditions (set drying oven (eight zones, 1 m each) to 70 to 140°C).

The operation of changing the drying conditions to a high temperature or a long time in order to lower the residual solvent ratio is not performed because the curing reaction hardly proceeds. Therefore, when the residual solvent ratio of the adhesive resin layer to be formed is reduced, drying is performed at a low processing speed. However, when the processing speed is excessively slow, productivity is deteriorated, which is not preferable.

As shown in the results shown in Table 4, when the thickness of the adhesive resin layer is 1.5 to 6 μm, processing can be performed at a processing speed of about 3 to 5 m/min, and productivity can be maintained. On the other hand, when the thickness of the adhesive resin layer is 9 μm, the processing speed is 1 m/min, and there is a concern about a decrease in productivity.

[Table 4]

| Thickness of adhesive resin layer | Processing speed |
|---|---|
| 9 μm | 1 m/min |
| 6 μm | 3 m/min |
| 1.5 μm | 5 m/min |

(Reference Example 11)

An electrolytic copper foil (CF-T9DA-SV manufactured by Fukuda Metal Foil & Powder Co., Ltd.) having a surface roughness Rzjis of 0.85 μm and a thickness of 18 μm was used as Reference Example 11.

(Reference Example 12)

An electrolytic copper foil (HS1-VSP manufactured by Mitsui Mining & Smelting Co., Ltd.) having a surface roughness Rzjis of 1.5 μm and a thickness of 18 μm was used as Reference Example 12.

<Production of laminate>

(Type of prepreg)

As prepregs, four types of polyphenylene ether resin prepregs were used. The polyphenylene ether resin prepreg is referred to as a "PPE-based prepreg".

(PPE-based prepreg)

- PPE-based prepreg 11 (PPE11): Meteorwave (registered trademark) 4000 manufactured by AGC Inc., thickness: 110.3 μm
- PPE-based prepreg 12 (PPE12): MEGTRON (registered trademark) 6 manufactured by Panasonic Industry Co., Ltd., thickness: 130.3 μm

- PPE-based prepreg 13 (PPE13): MEGTRON (registered trademark) 7 manufactured by Panasonic Industry Co., Ltd., thickness: 140.5 μm
- PPE-based prepreg 14 (PPE14): commercially available prepreg having a relative permittivity of 3.6 and a dielectric loss tangent of 0.0041 at 10 GHz, thickness: 100 μm

The adhesive-attached metal substrates of Examples 11 to 16 and Comparative Examples 11 and 12 were each laminated on both surfaces of a prepreg in the order of copper foil (metal layer)/adhesive resin layer/prepreg/adhesive resin layer/copper foil (metal layer).

When the metal substrate of Reference Example 11 was used, it was laminated in the order of copper foil (metal layer)/prepreg/copper foil (metal layer).

The lamination conditions vary depending on the type of prepreg, and lamination was performed under the conditions described in Table 5 below.

[Table 5]

| | Lamination conditions | |
|---|---|---|
| PPE-based prepreg 11 | 210°C, 60 min | 2.7 MPa |
| PPE-based prepreg 12 | 185°C, 75 min | 2.9 to 3.9 MPa |
| PPE-based prepreg 13 | 195°C, 75 min | 3 to 4 MPa |
| PPE-based prepreg 14 | 220°C, 60 min | 2 MPa |

Thus, laminates 11A to 11I, 12A to 12I, and 13A to 13I were produced.

<Measurement of adhesive strength>

For the obtained laminate, the adhesive strength between the copper foil (metal layer) and the prepreg was measured. The obtained laminate was cut into a width of 10 mm to prepare a test piece, the prepreg side was pasted on a ring core having a diameter of 11 cm, and the copper foil (metal layer) portion was pulled at a speed of 50 mm/min to perform a 90° peel test.

In this measurement, a case where the adhesive strength was 0.60 N/mm or more (3.4 lbs/inch or more) was evaluated as "adhesive strength can be sufficiently ensured". The adhesive strength of the produced laminate is described in Table 5.

Note that the adhesive strength is required to be 0.60 N/mm or more (3.4 lbs/inch or more) as an index of the adhesive strength between the prepreg and the metal layer, from the viewpoint of preventing peeling of the metal layer in the production process. Therefore, 0.60 N/mm or more (3.4 lbs/inch or more) was defined as an acceptable value.

<Solder heat resistance>

The produced laminate was left to stand in a thermostatic chamber at a temperature of 23°C and a humidity of 50% for 24 hours, and then floated in a solder bath at 288°C. The time until deformation or foaming occurred was measured to evaluate heat resistance. The results are shown in Tables 6 to 8. A case where deformation or foaming did not occur for 300 seconds was evaluated as acceptable.

<Measurement of dielectric characteristics>

For the obtained laminate, the copper foil (metal layer) was removed by etching to prepare a test piece (50 mm in width and 100 mm in length) in which the adhesive resin layer, the prepreg, and the adhesive resin layer were laminated in this order, the test piece dried at 135°C for 1 hour was defined as a test piece "after drying", and the test piece dried and thereafter further allowed to stand for 24 hours under the conditions of 23°C and a humidity of 50% was defined as a test piece "after humidity control". Dielectric characteristics were measured for each of the test pieces.

For dielectric characteristics, the relative permittivity and the dielectric loss tangent were measured at a frequency of 10 GHz by a split-post dielectric resonator method using a resonator manufactured by QWED Company.

The type of adhesive-attached metal substrate, the type of prepreg, adhesive strength, solder heat resistance, X/Y (X is the thickness (μm) of the adhesive resin layer, and Y is the thickness (μm) of the prepreg.), and dielectric characteristics of the laminates 11A to 11I, 12A to 12I, and 13A to 13I are shown in Tables 6 to 8.

[Table 6]

| | Adhesive- attached metal substrate | Prepreg | Adhesive strength measurement | | Solder heat resistance | | X/Y | Transmission characteristics | |
|---|---|---|---|---|---|---|---|---|---|
| | | | [N/mm] | Determination | [sec] | Determination | % | Relative permittivity (Dk) | Dielectric loss tangent (Df) |
| Laminate 11A | Comparative Example 11 | PPE11 | 0.82 | OK | 420 | OK | 9.1 | - | - |
| Laminate 11B | Example 11 | | 0.87 | OK | > 600 | OK | 5.4 | 3.61 | 0.0026 |
| Laminate 11C | Example 12 | | 0.80 | OK | > 600 | OK | 4.5 | - | - |
| Laminate 11D | Example 13 | | 0.88 | OK | > 600 | OK | 2.7 | - | - |
| Laminate 11E | Example 14 | | 0.83 | OK | > 600 | OK | 1.8 | - | - |
| Laminate 11F | Example 15 | | 0.86 | OK | > 600 | OK | 0.9 | - | - |
| Laminate 11G | Example 16 | | 0.76 | OK | > 600 | OK | 0.5 | | |
| Laminate 11H | Comparative Example 12 | | 0.41 | NG | > 600 | OK | 0.1 | - | - |
| Laminate 111 | Reference Example 11 | | 0.07 | NG | > 600 | OK | - | 3.66 | 0.0026 |

[Table 7]

| | Adhesive- attached metal substrate | Prepreg | Adhesive strength measurement | | Solder heat resistance | | X/Y | Transmission characteristics | |
|---|---|---|---|---|---|---|---|---|---|
| | | | [N/mml | Determination | [sec] | Determination | % | Relative permittivity (Dk) | Dielectric loss tangent (Df) |
| Laminate 12A | Comparative Example 11 | PPE12 | 0.79 | OK | 420 | OK | 7.7 | - | - |
| Laminate 12B | Example 11 | | 0.81 | OK | > 600 | OK | 4.6 | 3.83 | 0.0053 |
| Laminate 12C | Example 12 | | 0.81 | OK | > 600 | OK | 3.8 | - | - |
| Laminate 12D | Example 13 | | 0.76 | OK | > 600 | OK | 2.3 | - | - |
| Laminate 12E | Example 14 | | 0.75 | OK | > 600 | OK | 1.5 | - | - |
| Laminate 12F | Example 15 | | 0.76 | OK | > 600 | OK | 0.8 | - | - |
| Laminate 12G | Example 16 | | 0.77 | OK | > 600 | OK | 0.4 | - | - |
| Laminate 12H | Comparative Example 12 | | 0.54 | NG | > 600 | OK | 0.1 | - | - |
| Laminate 12I | Reference Example 11 | | 0.36 | NG | > 600 | OK | - | 4.00 | 0.0053 |

[Table 8]

| | Adhesive- attached metal substrate | Prepreg | Adhesive strength measurement | | Solder heat resistance | | X/Y | Transmission characteristics | |
|---|---|---|---|---|---|---|---|---|---|
| | | | [N/mm] | Determination | [sec] | Determination | % | Relative permittivity (Dk) | Dielectric loss tangent (Df) |
| Laminate 13A | Comparative Example 11 | | 0.75 | OK | 420 | OK | 7.1 | - | - |
| Laminate 13B | Example 11 | | 0.84 | OK | > 600 | OK | 4.3 | 3.32 | 0.0023 |
| Laminate 13C | Example 12 | | 0.70 | OK | > 600 | OK | 3.6 | - | |
| Laminate 13D | Example 13 | | 0.90 | OK | > 600 | OK | 2.1 | - | - |
| Laminate 13E | Example 14 | PPE13 | 0.74 | OK | > 600 | OK | 1.4 | - | |
| Laminate 13F | Example 15 | | 0.71 | OK | > 600 | OK | 0.7 | | - |
| Laminate 13G | Example 16 | | 0.66 | OK | > 600 | OK | 0.4 | - | |
| Laminate 13H | Comparative Example 12 | | 0.63 | OK | > 600 | OK | 0.1 | - | - |
| Laminate 131 | Reference Example 11 | | 0.56 | NG | > 600 | OK | - | 3.27 | 0.0022 |

As shown in Tables 6 to 8, a comparison between the laminate of Reference Example 11 and the laminate of each Example demonstrated that each Example had higher adhesive strength than Reference Example 11.

In addition, a comparison between the laminate of Example 11 and Comparative Example 11 demonstrated that the adhesive strength was equivalent therebetween. In Comparative Example 11 in which the film thickness of the adhesive resin layer was 10.0 μm, delamination was concerned from the evaluation result of the processing speed, which demonstrated the superiority of setting the thickness of the adhesive resin layer to 0.2 μm or more and 9 μm or less.

In addition, a comparison between the laminate of Example 11 and the laminate of Comparative Example 12 demonstrated that the adhesive strength of Comparative Example 12 was NG or lower than that of Example.

In addition, when the laminate of Example was compared with the laminate of Comparative Example 11, the transmission loss of Comparative Example 11 can be predicted to be superior to that of Example when the dielectric characteristics of the prepreg are worse than those of the adhesive resin layer, whereas the transmission loss can be predicted to be affected because the thickness of the adhesive resin layer is thick when the dielectric characteristics of the prepreg are better than those of the adhesive resin layer. Therefore, the thickness of the adhesive resin layer is preferably 9 μm or less in consideration of other performance.

When Example 11 was compared with Reference Example 11, the evaluation of the adhesive strength of Reference Example 11 was "NG", and the relative permittivity of Example was lower than that of Reference Example 11. For this reason, it was confirmed that both the adhesive strength and the transmission characteristics of Example were better than those of Reference Example 11.

<Measurement of transmission characteristics>

Laminates of Example 21, Comparative Example 21, and Comparative Example 22 shown in the following Table 9 were produced.

[Table 9]

| | Adhesive-attached metal substrate | Prepreg | Thickness (μm) of each layer | | | Adhesive strength measurement | |
|---|---|---|---|---|---|---|---|
| | | | Copper foil | Adhesive resin layer | Prepreg | [N/mm] | [lbs/inch] |
| Example 21 | Example 1 (Example 11) | PPE5 (PPE 14) | 18 | 6 | 100 | 0.84 | 4.80 |
| Comparative Example 21 | Reference Example 3 (Reference Example 12) | PPE5 (PPE 14) | 18 | 0 | 100 | 0.60 | 3.43 |
| Comparative Example 22 | Reference Example 2 (Reference Example 11) | PPE5 (PPE14) | 18 | 0 | 100 | 0.44 | 2.51 |

For the laminates of Example 21, Comparative Example 21, and Comparative Example 22, the transmission loss (dB/100 mm) was measured using the following apparatuses. The results are shown in Fig. 3.

[Apparatus]

KEYSIGHT TECHNOLOGIES, INC.

- 10 MHz to 67 GHz network analyzer

PNA Series N5227B

- 55 GHz to 95 GHz: frequency extender for WR12 signal analyzer

N9029AV12

As shown in Fig. 3, the transmission loss was smaller in Example 21 than in Comparative Example 21 and Comparative Example 22 even at a high frequency. Furthermore, as shown in Table 9, Example 21 also had high adhesive strength.

On the other hand, in Comparative Example 21 in which the surface roughness Rzjis was as high as 1.5 μm, the adhesive strength was able to be exhibited, but the higher the frequency, the higher the transmission loss.

In Comparative Example 22 in which the surface roughness Rzjis was 0.85 μm, the transmission loss was smaller than that in Comparative Example 21, but the adhesive strength was low because the adhesive resin layer was not included.

REFERENCE SIGNS LIST

1 Adhesive-attached metal substrate
2 Laminate
10 Metal layer
11 Adhesive resin layer
12 Prepreg

## Claims

1. An adhesive-attached metal substrate comprising a metal layer and an adhesive resin layer formed of an adhesive resin composition,

   wherein the metal layer has a surface roughness Rzjis of 1.5 μm or less,
   the adhesive resin composition contains a polyimide resin (A), a maleimide compound (B), and a radical initiator,
   a mass ratio between the polyimide resin (A) and the maleimide compound (B) is 10:1 to 3:2, and
   the content of the radical initiator, with respect to 100 parts by mass of the maleimide compound (B), is equal to or more than 1 part by mass and less than 25 parts by mass.

2. The adhesive-attached metal substrate according to claim 1, wherein the metal layer is a copper foil having a surface roughness Rzjis of less than 1.0 μm.

3. A laminate comprising the adhesive-attached metal substrate according to claim 1 or 2 on both surfaces of a prepreg,

   wherein the prepreg is laminated on a surface opposite a surface on which the adhesive resin layer included in the adhesive-attached metal substrate is in contact with the metal layer, and
   the prepreg is one or more selected from the group consisting of a modified polyimide resin prepreg, a polyester resin prepreg, a liquid crystal polymer prepreg, a cyclic olefin resin prepreg, a polyphenylene ether resin prepreg, a polyphenylene sulfide resin prepreg, a polyether ether ketone resin prepreg, a bismaleimide resin prepreg, a triazine resin prepreg, a bismaleimide-triazine resin prepreg, a benzocyclobutene resin prepreg, and a low dielectric epoxy resin prepreg.

4. An adhesive-attached metal substrate comprising a metal layer and an adhesive resin layer formed of an adhesive resin composition,

   wherein the adhesive resin composition contains a polyimide resin (A), a maleimide compound (B), and a radical initiator,
   a mass ratio between the polyimide resin (A) and the maleimide compound (B) is 10:1 to 3:2,
   the content of the radical initiator, with respect to 100 parts by mass of the maleimide compound (B), is equal to or more than 1 part by mass and less than 25 parts by mass, and
   the adhesive resin layer has a thickness of 0.2 μm or more and 9 μm or less.

5. The adhesive-attached metal substrate according to claim 4, wherein the metal layer is a copper foil having a surface roughness Rzjis of 1.0 μm or less.

6. A laminate comprising the adhesive-attached metal substrate according to claim 4 or 5 on both surfaces of a prepreg,

wherein the prepreg is laminated on a surface opposite a surface on which the adhesive resin layer included in the adhesive-attached metal substrate is in contact with the metal layer, and
the prepreg is one or more selected from the group consisting of a modified polyimide resin prepreg, a polyester resin prepreg, a liquid crystal polymer prepreg, a cyclic olefin resin prepreg, a polyphenylene ether resin prepreg, a polyphenylene sulfide resin prepreg, a polyether ether ketone resin prepreg, a bismaleimide resin prepreg, a triazine resin prepreg, a bismaleimide-triazine resin prepreg, a benzocyclobutene resin prepreg, and a low dielectric epoxy resin prepreg.

**7.** The laminate according to claim 6, wherein the adhesive resin layer has a thickness of 0.2 μm or more and 9 μm or less,

the prepreg has a thickness of 50 μm or more and 1000 μm or less,
the metal layer has a thickness of 1 μm or more and 35 μm or less, and
mathematical formula (1) below is satisfied:

$$0.05 \leqq (X/Y) \times 100 \leqq 7 \quad \cdots (1)$$

[in mathematical formula (1), X is the thickness (μm) of the adhesive resin layer, and Y is the thickness (μm) of the prepreg].

Fig. 1

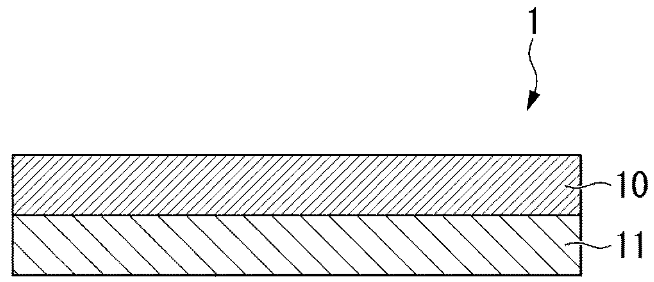


Fig. 2

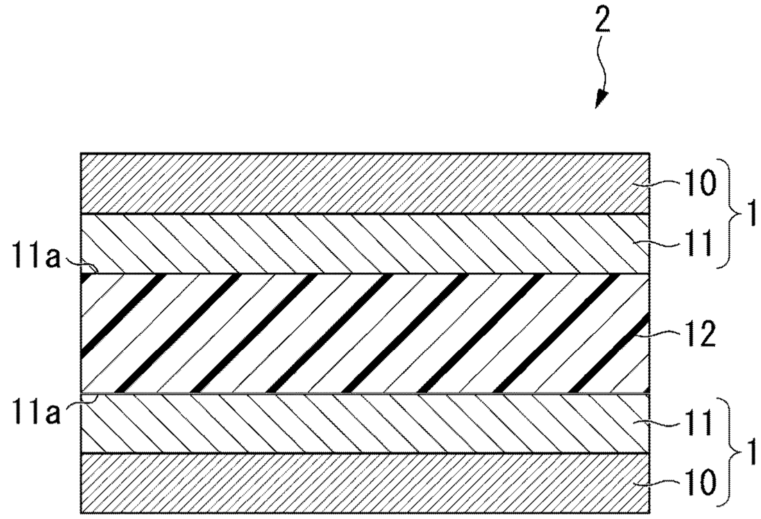

Fig. 3

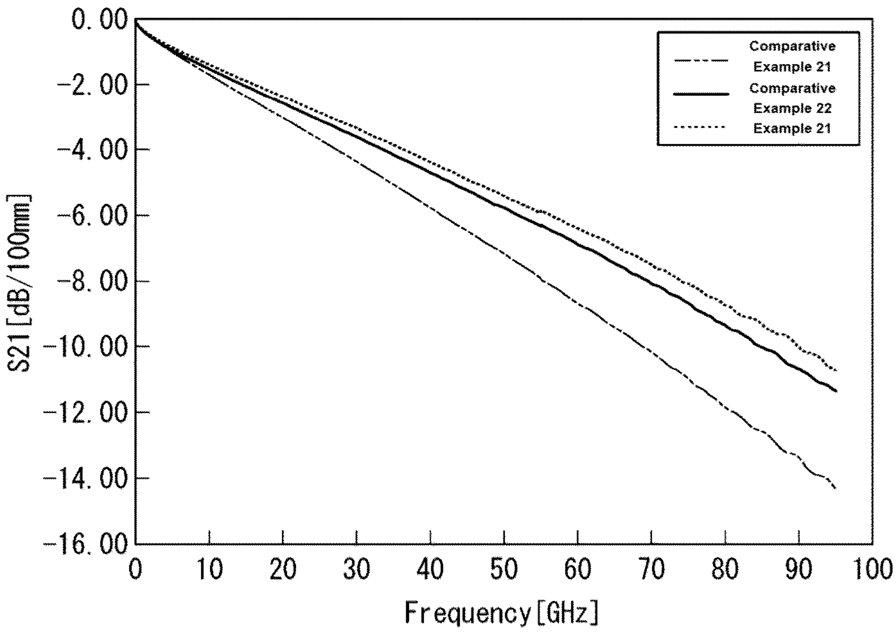
0.00
-2.00
-4.00
-6.00
-8.00
-10.00
-12.00
-14.00
-16.00
S21[dB/100mm]
0
10
20
30
40
50
60
70
80
90
100
Frequency[GHz]
Comparative Example 21
Comparative Example 22
Example 21

## INTERNATIONAL SEARCH REPORT

International application No.
**PCT/IB2024/052629**

**A. CLASSIFICATION OF SUBJECT MATTER**

***B32B 15/088***(2006.01)i; ***B32B 7/12***(2006.01)i; ***C09J 7/28***(2018.01)i; ***C09J 7/35***(2018.01)i; ***C09J 179/08***(2006.01)i; ***H05K 1/03***(2006.01)i
FI: B32B15/088; B32B7/12; C09J7/28; C09J7/35; C09J179/08 Z; H05K1/03 610H; H05K1/03 630G

According to International Patent Classification (IPC) or to both national classification and IPC

**B. FIELDS SEARCHED**

Minimum documentation searched (classification system followed by classification symbols)

B32B15/088; B32B7/12; C09J7/28; C09J7/35; C09J179/08; H05K1/03

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2022/004583 A1 (NIPPON KAYAKU KABUSHIKI KAISHA) 06 January 2022 (2022-01-06)<br>paragraph [0046], examples | 1,2 |
| A | paragraph [0046], examples | 3-7 |
| X | JP 2023-39241 A (NIPPON KAYAKU KABUSHIKI KAISHA) 20 March 2023 (2023-03-20)<br>paragraphs [0053], [0072], examples | 1-3 |
| A | paragraphs [0053], [0072], examples | 4-7 |
| P, X | JP 2023-68801 A (NIPPON KAYAKU KABUSHIKI KAISHA) 18 May 2023 (2023-05-18)<br>claims, paragraph [0082], examples | 1,2 |
| P, A | claims, paragraph [0082], examples | 3-7 |
| P, X | JP 2023-147328 A (FUJIMORI KOGYO CO., LTD.) 13 October 2023 (2023-10-13)<br>claims, paragraph [0012], examples | 1-6 |
| P, A | claims, paragraph [0012], examples | 7 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **20 May 2024** | **28 May 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**

International application No.
**PCT/IB2024/052629**

**C. DOCUMENTS CONSIDERED TO BE RELEVANT**

| Category* | Citation of document, with indication, where appropriate, of the relevant passages | Relevant to claim No. |
|---|---|---|
| P, X | JP 2023-147329 A (FUJIMORI KOGYO CO., LTD.) 13 October 2023 (2023-10-13)<br>claims, paragraph [0012], examples, fig. 2 | 4, 6, 7 |
| P, A | claims, paragraph [0012], examples, fig. 2 | 1-3, 5 |

Form PCT/ISA/210 (second sheet) (July 2022)

**INTERNATIONAL SEARCH REPORT**
**Information on patent family members**

International application No.
**PCT/IB2024/052629**

| Patent document cited in search report | Publication date (day/month/year) | Patent family member(s) | Publication date (day/month/year) |
|---|---|---|---|
| WO 2022/004583 A1 | 06 January 2022 | US 2023/0331915 A1<br>paragraph [0074], examples<br>CN 115777003 A<br>KR 10-2023-0029931 A<br>TW 202219116 A | |
| JP 2023-39241 A | 20 March 2023 | (Family: none) | |
| JP 2023-68801 A | 18 May 2023 | (Family: none) | |
| JP 2023-147328 A | 13 October 2023 | WO 2023/187624 A1<br>claims, paragraph [0012], examples | |
| JP 2023-147329 A | 13 October 2023 | WO 2023/187625 A1<br>claims, paragraph [0012], examples, fig. 2 | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2021003886 A
- WO 2022004583 A
- JP H9012712 A